# EUROPEAN PATENT SPECIFICATION

(11) **EP 4 356 159 B1**
(45) Date of publication and mention of the grant of the patent: **02.04.2025**
(21) Application number: 21758163.6
(22) Date of filing: 10.08.2021
(51) Int. Cl.: G01S 7/481, B60R 11/04, G01S 17/931, H05K 7/20

(54) **THERMAL MANAGEMENT SYSTEM FOR SENSORS WITH ELECTRONIC AND/OR OPTICAL COMPONENTS**
WÄRMEMANAGEMENTSYSTEM FÜR SENSOREN MIT ELEKTRONISCHEN UND/ODER OPTISCHEN KOMPONENTEN
SYSTÈME DE GESTION THERMIQUE DE CAPTEURS À COMPOSANTS ÉLECTRONIQUES ET/OU OPTIQUES

(30) Priority: 09.08.2021 PT 2021117390
(43) Date of publication of application: 24.04.2024
(73) Proprietor: Bosch Car Multimedia Portugal, S.A., 4705-820 Braga (PT); Universidade do Minho, 4700-320 Braga (PT)
(72) Inventor: CARDOSO LIMA, André Manuel, 4800-058 Guimarães (PT); DO CÉU GRAMAXO OLIVEIRA SAMPAIO, Álvaro Miguel, 4800-058 Guimarães (PT); VILELA PONTES, António José, 4800-058 Guimarães (PT); DELDUQUE BRAVO LOPES, Bruno, 4715-352 Braga (PT); BARROS CUNHA NUNES, João Guilherme, 4990-181 Ponte de Lima (PT); CERQUEIRA CORREIA, Pedro Miguel, 4730-550 Prado (São Miguel) (PT); MORAIS GOMES DOS SANTOS, João André, 4440-536 Valongo (PT)
(74) Representative: Couto, Cláudia
(86) International application number: PCT/IB2021/057378
(87) International publication number: WO 2023/017295

(56) References cited:
- DE-A1- 102017 216 241
- DE-A1- 102018 212 983
- DE-A1- 102018 221 880
- DE-A1- 102018 221 899
- DE-A1- 102018 222 449
- DE-A1- 102019 133 000
- DE-A1- 102019 201 417
- DE-A1- 102019 219 557
- US-A1- 2017 261 273
- US-A1- 2020 064 448
- US-A1- 2020 079 178
- US-A1- 2020 292 669
- US-A1- 2020 386 864
- US-A1- 2021 063 093
- US-A1- 2022 034 690
- US-B1- 11 240 932

## Description

### Technical field

This invention relates to the field of sensor systems for autonomous driving. The invention discloses a thermal management system for sensors with electronic and/or optical components that are sensitive to temperature variations.

### Background art

An optical sensor needs a powerful thermal management solution to ensure a stable operation in harsh temperature environments. Common reliable solutions exist in the market, which are widely used and have several variations and applications, such as thermoelectric coolers, heat sinks, thermal bridges and fans.

The electronics inside this type of sensor are complex and can produce high amounts of heat, but also have minimum temperature requirements to operate without failure. The same can be considered for optical components inside the sensor, which will be directly affected by the temperature generated by electronic components. For example, due to the coefficient of thermal expansion (CTE) of materials on the Printed Circuit Boards (PCBs) and the large temperature gradient between their components, problems can occur on the soldering paths caused by direct influence of temperature or stress accumulation. The optical elements might suffer a shift of the working wavelength or focal distance that will translate to bad/null distance readings.

At this moment, sensor cooling is achieved using the placement of fans in thermally sensitive areas or using cooling components such as thermoelectric cooling (TECs). These components also increase the complexity of the system and allow for a point of failure to exist in the operational life of the sensor.

In the field of autonomous cars and driving, LiDAR (Light Detection and Ranging) systems can measure the distance of every point in the scene, using the same principle as RADAR developed for a wide range of locating, ranging, and profiling applications. In simple terms, LiDAR is a remote sensing method that uses light to measure the distance to the object/surrounding, and an example of a sensor that can benefit from the present invention.

US 2021/063093 A1 discloses a thermal management system for LiDAR sensors with electronic and/or optical components, comprising an external housing covering an internal housing forming a duct there-between, wherein a cooling airflow is forced in the duct comprised between the external housing and the internal housing and dissipates heat from a heat exchanger in thermal contact with a sensor arranged in the internal housing.

US 2017/261273 A1 discloses a thermal management system for LiDAR sensors comprising a single housing containing the sensor and a liquid-to-air heat exchanger coupled to the housing, wherein the heated air circulating within housing is cooled by the liquid circulating in the heat exchanger.

### Summary

The present invention relates to a thermal management system (1) for sensors with electronic and/or optical components, comprising:
- an external housing (2) covering an internal housing (3), the external housing (2) comprising a first fluid path (5) and the internal housing (3) comprising a second fluid path (6), wherein the first and second fluid paths (5,6) form a circuit suitable for a refrigerating fluid to circulate;
- a thermal insulator layer (4) arranged between the external housing (2) and the internal housing (3);
- a fluid circulation system (7) connected to the first fluid path (5) and the second fluid path (6);
wherein the external housing (2) and internal housing (3) are made of a material with high thermal conductivity and the thermal insulator layer (4) is made of a material that has lower thermal conductivity than the external housing (2) and internal housing (3) material.

In one embodiment the external housing (2) comprises fins (8) arranged in its surface.

In another embodiment the first fluid path (5) is arranged on said fins (8).

In another embodiment the external housing (2) and internal housing (3) are made of a material selected from aluminium alloys, copper, brass, gold, silver, platinum or titanium.

In yet another embodiment, the thermal insulator layer (4) is made of a material selected from polyurethane, cork, extruded polystyrene, expanded polystyrene, stone wool insulation, glass wool, wood materials.

In one embodiment the refrigerating fluid is selected from water, a mixture of glycol and water, or oils.

In one embodiment the first fluid path (5) and second fluid path (6) are arranged inside the material of the external housing (2) and the internal housing (3) respectively.

In another embodiment the fluid circulation system (7) is a pump.

In one embodiment the thermal management system (1) has the shape of a dome.

In one embodiment the sensor with electronic and/or optical components is a LiDAR.

In another embodiment the thermal management system (1) further comprises at least two temperature sensors configured to measure the external temperature to the thermal management system (1) and the internal temperature of the thermal management system (1) and activate the fluid circulation system (7) when the temperature measured is above the operating temperature of the sensor with electronic and/or optical components.

The present invention also relates to the use of the thermal management system (1) in an autonomous car.

The present invention also relates to an autonomous car comprising the thermal management system (1).

### General description

All materials, processes and systems are affected by extreme temperature changes. These changes might have positive or negative influence on the system's performance. During the development of any electronic and/or optical sensor, several solutions must be applied to minimize any negative consequences of temperature variation, which can happen due to internal or external factors, such as heat generation from components or environment temperature changes.

The present invention is configured as a thermal management system for sensors with electronic and/or optical components that are sensitive to temperature variations.

The LiDAR sensor is not an exception to thermal sensitivity, as it will be exposed to all kinds of weather conditions, while integrated electronics will produce heat.

The solution proposed herein can be used to thermally manage electronic/optical sensors (e.g., LiDAR), that can be exposed, under work, from low external temperatures to high temperatures. This solution is capable to manage the thermal behavior inside the sensors' most thermally fragile areas.

One of the core LiDAR sub-systems and the most sensitive to temperature variation is the optics system. Optical properties of materials are temperature sensitive and the entire system's thermal analysis depends on several variables.

The LiDAR sensor is a complex device composed by several components, on which most of them generate heat while being compactly mounted inside a hermetic enclosure. Each component has a working temperature limit that shall be respected. To protect the components from overheating or freezing there must be an implemented thermal management solution. The thermal management of the LiDAR is a crucial topic due to the challenging automotive requirements and the temperature variation can affect the optics system performance. Optics is one of the most temperature sensitive systems in the sensor, as it can suffer misalignments or transmissibility gap changes even with minor variations.

Cycles of repeated high temperature range changes performed over the product life cycle have the potential to create fatigue and affect the overall performance of the system. To overcome these issues, an optimized thermal management is crucial, namely an adaptive thermal management system capable of using exterior temperature measurements to adapt the conditions of areas with temperature sensitive materials.

From a low external temperature (e.g. -40°C) to a temperature that allows the internal components of the sensor to work properly (e.g. 20°C/30°C), and up to higher external temperatures (e.g 85°C), the presently disclosed system is suitable to manage the thermal conditions inside the sensor with electronic and/or optical components in order to provide the correct range of temperature for the sensor to work properly.

The application of the present invention is in the automotive area in which the electronic and optical components must fulfil certain requirements, such as operate under external temperatures (i.e. environmental temperatures) that can vary from -40°C up to 85°C without being damaged. According to ISO 16750-4 from 2010 and ISO 16750-1 from 2018 the electronic devices for automotive applications should fulfil these temperatures to operate in the car body exterior.

### Brief description of drawings

For easier understanding of this application, figures are attached in the annex that represent the preferred forms of implementation which nevertheless are not intended to limit the technique disclosed herein.
Figure 1 shows an embodiment of the thermal management system (1) of the present application.
Figure 2 shows a vertical cross section of an embodiment of the thermal management system (1) of the present application.
Figure 3 shows a vertical cross section of an embodiment of the thermal management system (1) of the present application, evidencing the first and second fluid circuits (5,6).
Figure 4 shows an embodiment of the thermal management system (1) of the present application.

### Description of embodiments

Now, preferred embodiments of the present application will be described in detail with reference to the annexed drawings. However, they are not intended to limit the scope of the invention.

The present application relates to a thermal management system for sensors with electronic and/or optical components that are sensitive to temperature variation. More precisely, the present invention relates to the thermal management of sensor systems for autonomous cars.

The present invention aims to solve two technical problems simultaneously, which affect sensors with electronic and/or optical components.

One problem is the heat generated by the electrical components inside the sensor. These components produce heat during operation which increases the temperature inside the sensor and can lead to failure and damage of the components. In this case, the present invention, which comprises a refrigerating system, manages the temperature of the sensor and assures that the temperature inside the same does not increase to values that can cause damage to the components.

The other problem is related to temperature variations external to the sensor (i.e. environmental temperature surrounding the sensor), and the invention assures that the sensor, and its components, are maintained within a temperature range in which the sensor is able to operate without the electronic and/or optical components suffering failure or damage.

When the external temperature is higher than the temperature inside the sensor, which inside a car can reach up to 85°C, the heat gradient is reversed, and other solutions such as heat sinks (passive heat exchangers) exacerbate the temperature problem.

In the present invention, a refrigerating fluid is used to remove heat from the inside of the sensor (generated by the operation of the electrical components themselves). When the external temperature is below the internal components' upper operating temperature limit, the static system is used, i.e. both housing and insulator layer act as an insulator. Above this temperature, the pumping of the fluid can allow for the internal heat to be transferred to the external housing, which in turn will dissipate to the environment. When the external temperature is higher than the components' upper temperature limit, the refrigerating fluid will act as a heat absorber that can be pumped the heat out of the system, in applications where it could be used elsewhere (i.e. heated water for cleaning systems).

The present invention consists in a closed circuit that comprises a refrigerating fluid that flows through the system's housings, which controls the temperature of electronic and/or optical components of a sensor placed inside the system, by the design of the fluid circuit path and available section for heat transfer.

The thermal management system of the present invention is configured to cover or enclosure a sensor comprising electronic and/or optical components and can accommodate wider operational temperatures for electronic and/or optical sensitive products. Thus, the invention can minimize the risk of failure of the electronic and optical components of said sensors.

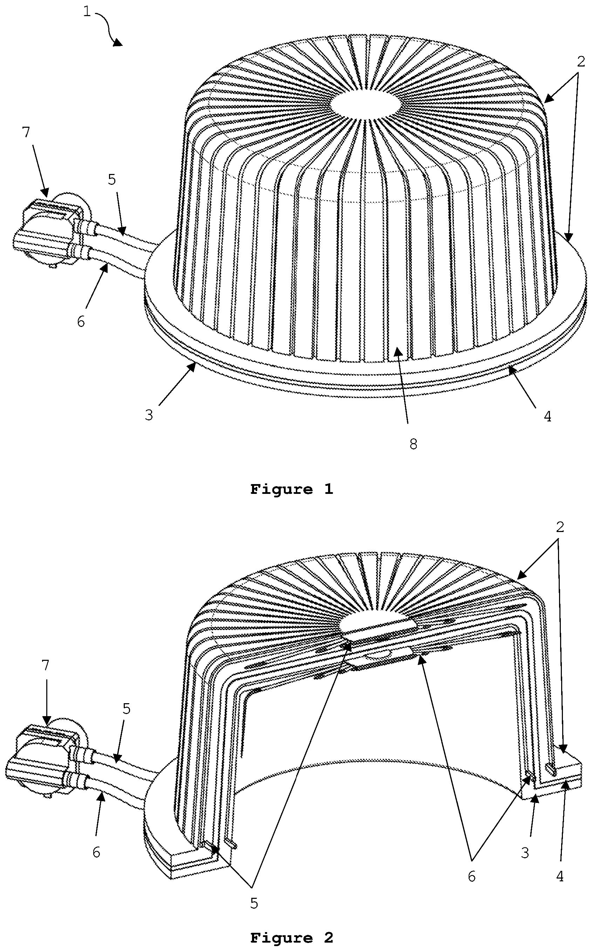

Figure 1 shows an embodiment of the thermal management system (1) of the present application in the arrangement of its preferred intended use.

According to Figures 1 and 2, the thermal management system (1) comprises an external housing (2) and an internal housing (3) wherein the external housing (2) covers the internal housing (3), as seen in Figure 1, and a thermal insulator layer (4) is arranged between the external housing (2) and the internal housing (3), as shown in Figure 2.

In one embodiment, the external housing (2) and internal housing (3) are made of a material selected from, but not limited to, aluminium alloys, copper, brass, gold, silver, platinum or titanium.

The external and internal housing (2,3) are configured as heat exchangers, while the thermal insulator layer (4) is configured as an insulating layer.

The material selected for the external housing (2) and internal housing (3) must have high thermal conductivity.

The thermal insulator layer (4) is made of a material selected from, but not limited to polyurethane (PU), cork, extruded polystyrene (XPS), expanded polystyrene (EPS), stone wool insulation, glass wool, wood materials or other materials with similar thermal conductivity.

The thermal insulator layer (4) has lower thermal conductivity than the external and internal housings (2,3). For example, PU has 0.06 W/m.K (in function of its density) and cork has 0.039 W/mK of thermal conductivity.

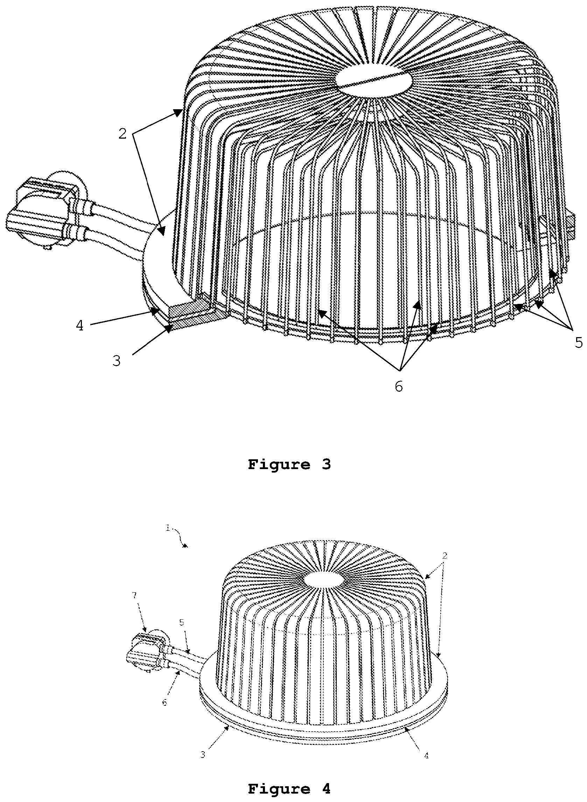

The external housing (2) comprises a first fluid path (5) and the internal housing (3) comprises a second fluid path (6), as shown in Figure 3.

The first and second fluid paths (5,6) form a circuit suitable for a refrigerating fluid to circulate. The refrigerating fluid that goes through the first fluid path (5) and second fluid path (6), which are channels where the refrigerating fluid circulates inside.

In one embodiment, the refrigerating fluid with high thermal capacity is selected from, but not limited to, from water, a mixture of glycol and water, or oils.

The first fluid path (5) and second fluid path (6) cross sections can have different geometrical shapes (e.g., square, circle, oval, etc.) and pathways in the external and internal housings (2,3), in order to control the temperature of a specific location inside an electronic/optical sensor according to the thermal needs of the sensor.

As shown in Figures 2 and 3, due to being part of the external housing (2) and internal housing (3) respectively, the first fluid path (5) and second fluid path (6) are arranged at each side of the thermal insulator layer (4).

In one embodiment, the first fluid path (5) and second fluid path (6) are arranged inside the material of the external and internal housing (2,3), respectively.

In another embodiment, the external housing (2) comprises fins (8) arranged in its surface, suitable for the dissipation of heat, and the first fluid path (5) is arranged on said fins (8), as shown in Figure 1. Said fins (8) are used to optimize the surface area of the external housing (2) and are suitable to increase the heat transfer, according to the heat transfer by convection formula. It is possible to use a smooth surface on the external housing (2), though the thermal performance might decrease. The presence of fins (8) can increase the thermal performance of the external housing (2).

The fins (8) geometry and/or size should be optimized for a specific solution/materials/thermal needs.

The thermal management system (1) further comprises a fluid circulation system (7) connected to the first fluid path (5) and the second fluid path (6).

The fluid circulation system (7) is any system that allows the refrigerating fluid to be introduced and circulated inside the first fluid path (5) and second fluid path (6). Together with the first and second fluid paths (5,6), the fluid circulation system (7) forms a closed circuit for the circulation of refrigerating fluid in the thermal management system (1).

In one embodiment, the fluid circulation system (7) is a pump.

The external housing (2) and internal housing (3) of the thermal management system (1) have a geometry that allows the fluid circulation to be in close proximity to thermally sensitive areas of the sensor, increasing the heat transfer capabilities of the invention, as shown in Figures 1 and 3. The shape of the thermal management system (1) is configured to cover or enclose the sensor with electronic and/or optical components for which the temperature must be managed.

In one embodiment, the thermal management system (1) has the shape of a dome. In another embodiment, the thermal management system (1) has the shape of a dome with a flat top as shown in Figure 1.

In one embodiment, the elements of the thermal management system (1) can be made in 3D printed parts, and there is freedom to design and produce the parts in the first and second fluid paths (5,6) wherever suits best regarding the thermal management of a certain sensor. In this manner, it is possible to produce fluid pathways that are more suitable for certain areas of the sensor which are more sensitive to temperature variation.

This is achieved also by varying the shape and size of the first and second fluid paths (5,6) and by the complexity of the fluid paths created.

The first and second fluid paths (5, 6) form a circuit created in part by means of subtractive manufacturing (e.g. drilling) or by different additive manufacturing technologies such as binder jetting, powder bed fusion, 3D printing, etc.

In order for the components of sensor with thermally sensitive components to work within the specified operating temperature range, this thermal management system (1) uses the refrigerating fluid circuit to control the exchange of heat between two housings on a progressive and controlled mode. To do so, it is required to force the circulation of a refrigerating fluid of high thermal capability and low freezing point, on a closed circuit, between two housings made of a material with high thermal conductivity. This thermal management system (1) has paths for fluid circulation, to exchange the heat between the two housings (2, 3).

The feasibility of these fluid circulating paths, namely the first fluid path (5) and second fluid path (6), will be very dependent on their manufacturing process.

Additive manufacturing is one of the most viable solutions available to produce the complex geometry of the thermal management system (1) as described. Taking into account that these parts must have high thermal conductivity, Direct Metal Laser Sintering (DMLS) / Selective Laser Melting (SLM) should be considered for their manufacture.

Figure 3 shows the three layers of material that constitute the internal and external housing (2,3), and an intermediate layer, the thermal insulator layer (4), which has lower thermal conductivity than the housings (2,3) and acts as the thermal insulating layer.

The arrangement of the thermal management system (1) parts prevents heat dissipation through thermal conduction, from the interior housing (3) to the exterior housing (2).

The high thermal conductivity of the housings materials allows to transfer the heat from the interior housing (3) to the refrigerating fluid, which transfers the heat to the external housing (2).

In one embodiment, the thermal management system (1) comprises a fluid circulation system (7) that will only activate the refrigerating fluid circulation when the external temperature increases and the heat inside the housing (2,3) also increases. This will dissipate the heat towards the circulating refrigerating fluid inside the first and second fluid paths (5,6), via convection, and direct it to the external housing (2), which will then be dissipated to the environment via thermal convection on the fins (8) present in the external housing (2).

The thermal management system (1) also takes advantage of at least two temperature sensors that are suitable to measure the external temperature to the thermal management system (1) and measure the internal temperature inside the thermal management system (1), respectively. The temperature sensors collect temperature data and are configured to communicate with the fluid circulation system (7) in order to activate said system when the temperature readings achieve a value above the operating temperature of the sensor with electronic and/or optical components.

In one embodiment the temperature sensors can be an integrated system in the sensor with electronic and/or optical components to which the thermal management must be provided, the temperature sensor being suitable to measure the temperature in the interior space formed by the housings (2,3) of the thermal management system (1) and/or measure the temperature near the electronic and/or optical components.

In one embodiment, the temperature sensors are part of an autonomous vehicle and can communicate with the thermal management system (1) in order to activate the refrigerating fluid circulation depending on the temperature readings of the temperature sensor.

In yet another embodiment, the temperature sensors are arranged in the thermal management system (1) itself.

The thermal management system (1) has two operation method modes:
When the sensor with electronic and/or optical components sensitive to temperature inside the thermal management system (1) is exposed to temperatures below the operating temperature range of the sensor, the temperature being measured by the at least two temperature sensors, the thermal management system (1) will operate with no refrigerating fluid circulation.

In this scenario, the heat released by the electronic and/or optical components will be kept inside the thermal management system (1) due to the thermal insulator layer (4), which is suitable to prevent the heat dissipation via thermal conduction, allowing the temperature to increase inside the thermal management system (1) and to achieve values within the electronic and/or optical components operating temperature range.

When the sensor with electronic and/or optical components sensitive to temperature is subjected to temperatures above the operating temperature limit of the sensor, the temperature being measured by the at least two temperature sensors, the thermal management system (1) will activate the refrigerating fluid circulation, creating a bypass of the insulating layer, allowing the heat to be dissipated to the environment through the external housing (2).

In one embodiment, the fluid circulation can be controlled progressively according to thermal data inside the housings provided by thermistors i.e., to control the speed of the heat exchange, allowing the system to accommodate a wider range of temperatures. The thermistors can control the thermal cycle paraments, such as the heat transfer or fluid speed.

The present invention, as previously described, presents the potential for application in sensors comprising electronic and/or optical components that are sensitive to temperature, such as LIDAR systems or any electronic enclosure, allowing a secure and optimized thermal management for the components and preventing mechanical and thermal damage.

The present invention is suitable to be used in autonomous cars, and for autonomous cars comprising the present invention.

## Claims

1. A thermal management system (1) for sensors with electronic and/or optical components, comprising:
- an external housing (2) covering an internal housing (3), the external housing (2) comprising a first fluid path (5) and the internal housing (3) comprising a second fluid path (6), wherein the first and second fluid paths (5,6) form a circuit suitable for a refrigerating fluid to circulate;
- a thermal insulator layer (4) arranged between the external housing (2) and the internal housing (3);
- a fluid circulation system (7) connected to the first fluid path (5) and the second fluid path (6);
wherein the external housing (2) and internal housing (3) are made of a material with high thermal conductivity and the thermal insulator layer (4) is made of a material that has lower thermal conductivity than the external housing (2) and internal housing (3) material.

2. Thermal management system (1) according to the previous claim, wherein the external housing (2) comprises fins (8) arranged in its surface.

3. Thermal management system (1) according to the previous claim, wherein the first fluid path (5) is arranged on said fins (8).

4. Thermal management system (1) according to any of the previous claims, wherein the external housing (2) and internal housing (3) are made of a material selected from aluminium alloys, copper, brass, gold, silver, platinum or titanium.

5. Thermal management system (1) according to any of the previous claims, wherein the thermal insulator layer (4) is made of a material selected from polyurethane, cork, extruded polystyrene, expanded polystyrene, stone wool insulation, glass wool, wood materials.

6. Thermal management system (1) according to any of the previous claims, wherein the refrigerating fluid is selected from water, a mixture of glycol and water, or oils.

7. Thermal management system (1) according to any of the previous claims, wherein the first fluid path (5) and second fluid path (6) are arranged inside the material of the external housing (2) and the internal housing (3) respectively.

8. Thermal management system (1) according to any of the previous claims, wherein the fluid circulation system (7) is a pump.

9. Thermal management system (1) according to any of the previous claims, wherein the thermal management system (1) has the shape of a dome.

10. Thermal management system (1) according to any of the previous claims, wherein the sensor with electronic and/or optical components is a LiDAR.

11. Thermal management system (1) according to any of the previous claims, wherein the thermal management system (1) further comprises at least two temperature sensors configured to measure the external temperature to the thermal management system (1) and the internal temperature of the thermal management system (1) and configured to activate the fluid circulation system (7) when the temperature measured is above the operating temperature of the sensor with electronic and/or optical components.

12. Use of the thermal management system (1) described in any of the claims 1 to 11, in an autonomous car.

13. Autonomous car comprising the thermal management system (1) described in any of the claims 1 to 11.

## Patentansprüche

1. Wärmemanagementsystem (1) für Sensoren mit elektronischen und/oder optischen Komponenten, umfassend:
- ein äußeres Gehäuse (2), das ein inneres Gehäuse (3) abdeckt, wobei das äußere Gehäuse (2) einen ersten Flüssigkeitspfad (5) und das innere Gehäuse (3) einen zweiten Flüssigkeitspfad (6) umfasst, wobei der erste und der zweite Flüssigkeitspfad (5, 6) einen Kreislauf bilden, der für die Zirkulation einer Kühlflüssigkeit geeignet ist;
- eine thermische Isolationsschicht (4), die zwischen dem äußeren Gehäuse (2) und dem inneren Gehäuse (3) angeordnet ist;
- ein Flüssigkeitszirkulationssystem (7), das mit dem ersten Flüssigkeitspfad (5) und dem zweiten Flüssigkeitspfad (6) verbunden ist;
wobei das äußere Gehäuse (2) und das innere Gehäuse (3) aus einem Material mit hoher Wärmeleitfähigkeit hergestellt sind und die thermische Isolationsschicht (4) aus einem Material hergestellt ist, das eine geringere Wärmeleitfähigkeit als das Material des äußeren Gehäuses (2) und des inneren Gehäuses (3) aufweist.

2. Wärmemanagementsystem (1) nach dem vorhergehenden Anspruch, wobei das äußere Gehäuse (2) Rippen (8) aufweist, die in seiner Fläche angeordnet sind.

3. Wärmemanagementsystem (1) nach dem vorhergehenden Anspruch, wobei der erste Flüssigkeitspfad (5) auf den Rippen (8) angeordnet ist.

4. Wärmemanagementsystem (1) nach einem der vorhergehenden Ansprüche, wobei das äußere Gehäuse (2) und das innere Gehäuse (3) aus einem Material bestehen, das aus Aluminiumlegierungen, Kupfer, Messing, Gold, Silber, Platin oder Titan ausgewählt ist.

5. Wärmemanagementsystem (1) nach einem der vorhergehenden Ansprüche, wobei die thermische Isolationsschicht (4) aus einem Material besteht, das aus Polyurethan, Kork, extrudiertem Polystyrol, expandiertem Polystyrol, Steinwollisolierung, Glaswolle und Holzmaterialien ausgewählt ist.

6. Wärmemanagementsystem (1) nach einem der vorhergehenden Ansprüche, wobei die Kühlflüssigkeit aus Wasser, einer Mischung aus Glykol und Wasser oder Ölen ausgewählt ist.

7. Wärmemanagementsystem (1) nach einem der vorhergehenden Ansprüche, wobei der erste Flüssigkeitspfad (5) und der zweite Flüssigkeitspfad (6) jeweils innerhalb des Materials des äußeren Gehäuses (2) und des inneren Gehäuses (3) angeordnet sind.

8. Wärmemanagementsystem (1) nach einem der vorhergehenden Ansprüche, wobei das Flüssigkeitszirkulationssystem (7) eine Pumpe ist.

9. Wärmemanagementsystem (1) nach einem der vorhergehenden Ansprüche, wobei das Wärmemanagementsystem (1) die Form einer Kuppel hat.

10. Wärmemanagementsystem (1) nach einem der vorhergehenden Ansprüche, wobei der Sensor mit elektronischen und/oder optischen Komponenten ein LiDAR ist.

11. Wärmemanagementsystem (1) nach einem der vorhergehenden Ansprüche, wobei das Wärmemanagementsystem (1) ferner mindestens zwei Temperatursensoren umfasst, die so konfiguriert sind, dass sie die Außentemperatur des Wärmemanagementsystems (1) und die Innentemperatur des Wärmemanagementsystems (1) messen und so konfiguriert sind, dass sie das Flüssigkeitszirkulationssystem (7) aktivieren, wenn die gemessene Temperatur oberhalb der Betriebstemperatur des Sensors mit elektronischen und/oder optischen Komponenten liegt.

12. Verwendung des in einem der Ansprüche 1 bis 11 beschriebenen Wärmemanagementsystems (1) in einem autonomen Fahrzeug.

13. Autonomes Fahrzeug mit dem in einem der Ansprüche 1 bis 11 beschriebenen Wärmemanagementsystem (1).

## Revendications

1. Système de gestion thermique (1) de capteurs à composants électroniques et/ou optiques, comprenant :
- un boîtier extérieur (2) recouvrant un boîtier intérieur (3), le boîtier extérieur (2) comprenant un premier chemin fluidique (5) et le boîtier intérieur (3) comprenant un second chemin fluidique (6), les premier et second chemins fluidiques (5, 6) formant un circuit adapté à la circulation d'un fluide réfrigérant ;
- une couche d'isolant thermique (4) disposée entre le boîtier extérieur (2) et le boîtier intérieur (3) ;
- un système de circulation fluidique (7) relié au premier chemin fluidique (5) et au second chemin fluidique (6) ;
dans lequel le boîtier extérieur (2) et le boîtier intérieur (3) sont constitués d'un matériau à conductivité thermique élevée et la couche d'isolant thermique (4) est constituée d'un matériau qui présente une conductivité thermique inférieure à celle du matériau du boîtier extérieur (2) et du boîtier intérieur (3).

2. Système de gestion thermique (1) selon la revendication précédente, dans lequel le boîtier extérieur (2) comprend des ailettes (8) disposées à sa surface.

3. Système de gestion thermique (1) selon la revendication précédente, dans lequel le premier chemin fluidique (5) est disposé sur lesdites ailettes (8).

4. Système de gestion thermique (1) selon l'une quelconque des revendications précédentes, dans lequel le boîtier extérieur (2) et le boîtier intérieur (3) sont constitués d'un matériau choisi parmi des alliages d'aluminium, le cuivre, le laiton, l'or, l'argent, le platine ou le titane.

5. Système de gestion thermique (1) selon l'une quelconque des revendications précédentes, dans lequel la couche d'isolant thermique (4) est constituée d'un matériau choisi parmi le polyuréthane, le liège, le polystyrène extrudé, le polystyrène expansé, l'isolant en laine de roche, la laine de verre, des matériaux en bois.

6. Système de gestion thermique (1) selon l'une quelconque des revendications précédentes, dans lequel le fluide réfrigérant est choisi parmi l'eau, un mélange de glycol et d'eau, ou des huiles.

7. Système de gestion thermique (1) selon l'une quelconque des revendications précédentes, dans lequel le premier chemin fluidique (5) et le second chemin fluidique (6) sont disposés à l'intérieur du matériau du boîtier extérieur (2) et du boîtier intérieur (3) respectivement.

8. Système de gestion thermique (1) selon l'une quelconque des revendications précédentes, dans lequel le système de circulation fluidique (7) est une pompe.

9. Système de gestion thermique (1) selon l'une quelconque des revendications précédentes, dans lequel le système de gestion thermique (1) a la forme d'un dôme.

10. Système de gestion thermique (1) selon l'une quelconque des revendications précédentes, dans lequel le capteur à composants électroniques et/ou optiques est un LiDAR.

11. Système de gestion thermique (1) selon l'une quelconque des revendications précédentes, dans lequel le système de gestion thermique (1) comprend en outre au moins deux capteurs de température configurés pour mesurer la température extérieure au système de gestion thermique (1) et la température intérieure du système de gestion thermique (1) et configurés pour activer le système de circulation fluidique (7) lorsque la température mesurée est supérieure à la température de fonctionnement du capteur à composants électroniques et/ou optiques.

12. Utilisation du système de gestion thermique (1) décrit dans l'une quelconque des revendications 1 à 11, dans une voiture autonome.

13. Voiture autonome comprenant le système de gestion thermique (1) décrit dans l'une quelconque des revendications 1 à 11.
